# EUROPÄISCHE PATENTSCHRIFT

(11) **EP 0 823 978 B1**
(45) Veröffentlichungstag und Bekanntmachung des Hinweises auf die Patenterteilung: **16.06.1999**
(21) Anmeldenummer: 96913510.2
(22) Anmeldetag: 18.04.1996
(51) Int. Cl.: G03F 9/00

(54) **VERFAHREN UND VORRICHTUNG ZUR ANPASSUNG DER LAGE VON DRUCKPLATTEN AN DIE VERFORMUNG DES ZU BEDRUCKENDEN PAPIERES**
PROCESS AND DEVICE FOR ADAPTING THE POSITION OF PRINTING PLATES TO THE DEFORMATION OF THE PAPER TO BE PRINTED
PROCEDE ET DISPOSITIF POUR L'ADAPTATION DE LA POSITION DE PLAQUES D'IMPRESSION A LA DEFORMATION DU PAPIER A IMPRIMER

(30) Priorität: 04.05.1995 DE 19516368
(43) Veröffentlichungstag der Anmeldung: 18.02.1998
(73) Patentinhaber: Brüder Neumeister Gmbh, 77933 Lahr (DE)
(72) Erfinder: BRITSCH, Helmut, D-77948 Friesenheim (DE)
(74) Vertreter: Schmitt, Hans, Dipl.-Ing.
(86) Internationale Anmeldenummer: EP9601620
(87) Internationale Veröffentlichungsnummer: WO9635147

(56) Entgegenhaltungen:
- EP-A- 0 229 892
- DE-A- 3 905 093
- FR-A- 1 310 834

## Beschreibung

Die Erfindung betrifft ein Verfahren zur Anpassung der Lage von Druckplatten an die Verformung (fan-out) des zu bedruckenden Papieres durch Feuchtigkeit und Farbaufnahme beim Durchlauf durch mehrere hintereinander angeordnete Paare von Druckwalzen und/oder zur Anpassung an an der Einspannvorrichtung einer Druckwalze auftretende Verformungen und dadurch erzeugte Lageänderungen einer jeweiligen Druckplatte, wobei die Druckplatte bei ihrer Herstellung mit Markierungen für eine lagegenaue Stanzung und/oder Biegung versehen und damit in eine Stanz- und/oder Biegemaschine eingelegt und den Markierungen gemäß darin justiert und ausgerichtet wird.

Die Erfindung betrifft außerdem eine Vorrichtung zur Durchführung dieses Verfahrens mit einer Stanz- und/oder Biegemaschine zum Anbringen der Stanzung für die Registerstifte von Druckwalzen an Druckplatten und/oder für die Umbiegung zur Befestigung der entsprechenden Druckplatte an der Druckwalze.

Aus EP-A-0 229 892 ist es bekannt, daß insbesondere beim Farbdruck das zu bedruckende Papier bei dem dazu erforderlichen Durchlauf durch mehrere Druckwalzenpaare in seiner quer zum Vorschub orientierten Breite zunimmt oder gegebenenfalls sogar abnimmt, je nachdem, wieviel Feuchtigkeit dabei aufgenommen wird und welche Struktur das Papier hat. Diese Erscheinung wird in der Fachwelt als "fan-out" bezeichnet.

Vor allem bei der Herstellung von Farbdrucken kann es dadurch zu einer Verschiebung einer Farbe gegenüber der anderen oder gegenüber dem eigentlichen Druckfeld kommen, was einen unsauberen und unangenehmen Druck ergibt und allenfalls bei billigen Druckwerken akzeptiert wird.

In der EP-A-0 229 892 wird zur Abhilfe beschrieben, solche im Verlauf der Papierbahn auftretende Maßänderungen dadurch zu korrigieren, daß die Registerstifte für die Druckplatten an den Druckwalzen verstellt werden, das heißt die Registerstifte müssen in konstruktiv aufwendiger Weise auch verstellbar vorgesehen werden. Der Drucker muß im Rahmen einer Vielzahl von Probedrucken die Registerstifte so einstellen, daß für die jeweilige Papiersorte bei dem jeweils durchzuführenden Druck der auftretende Papierbahnfehler ausgeglichen wird.

Wird dann jedoch mit derselben Druckmaschine eine andere Papiersorte bedruckt, muß die Korrektur wiederholt werden, weil dieses andere Papier einen anderen fan-out hat. Dies ist nicht nur zeitaufwendig und schwierig und bedarf sehr großer Erfahrung, sondern bleibt trotzdem fehlerträchtig.

Es besteht deshalb die Aufgabe, ein Verfahren und eine Vorrichtung der eingangs genannten Art zu schaffen, womit die Maßänderungen von Papierbahnen auf einfachere Weise berücksichtigt werden können, so daß weniger Zeitverlust beim Wechsel von einer Papierbahn auf die andere an der Druckmaschine auftritt und weniger Fehldrucke notwendig sind, trotzdem aber ein gutes Druckergebnis selbst bei Mehrfarbendruck erzielt werden kann.

Zur Lösung dieser scheinbar widersprüchlichen Aufgabe ist bei dem eingangs genannten Verfahren vorgesehen, daß die Druckplatte bzw. die sie in der Stanz- und/oder Biegemaschine aufnehmende Halterung um diejenigen Maße in seitlicher Richtung, in Umfangsrichtung und/oder in ihrer Winkelstellung verstellt wird, die diese Druckplatte an der Druckwalze aufgrund der Verformung des zu bedruckenden Papieres benötigt, um einen mit einer in Vorschubrichtung der Papierbahn vorhergehenden Druckwalze übereinstimmenden Druck trotz der inzwischen erfolgten Papierverformung zu bewirken und wonach die Verformungen an dieser aus ihrer Nullage verstellten Druckplatte, also Umbiegungen und/oder Stanzungen, angebracht werden.

Die Druckplatte wird also mit einer scheinbar fehlerhaften Umbiegung und/oder Stanzung versehen, woei dieser "Fehler" der Maßabweichung entspricht, die durch die Papierverformung bzw. den fan-out entsteht. Ein Verstellen von Registerstiften ist also nicht mehr erforderlich.

Besonders zweckmäßig ist es dabei, wenn die Druckplatte in der Stanz- und/oder Biegemaschine mit Hilfe wenigstens einer oder zweier Meßvorrichtunuen, z.B. optoelektronischer Meßvorrichtungen, Lasertechnik, Infrarottechnologie Schallwellenoder Ultraschallwellentechnologie, insbesondere mit Hilfe wenigstens zweier Videokameras ausgerichtet wird, welche Meßvorrichtungen die Markierungen erfassen, und daß die Druckplatten so verstellbar sind, daß die jeweils zu erwartende Papierverfomung berücksichtigt wird. Es kann also zunächst die korrekte Nullage der Druckplatte in der Stanz- und/oder Biegemaschine gemäß der zuvor genau angebrachten Markierung eingestellt werden. Anschließend können die Druckplatten so verstellt werden, wie es zur Berücksichtigung von Papierverformungen an der Druckwalze außerhalb der eigentlichen genauen Befestigungsstelle erforderlich ist, was mit Hilfe der Meßgeräte und der Markierungen geschehen kann, und dann können die Stanzungen und/oder Umbiegungen durchgeführt werden, so daß die entsprechende Maßabweichung schon an der Druckplatte selbst berücksichtigt ist. Muß die Druckplatte an der Druckwalze beispielsweise in Vorschubrichtung gesehen etwas weiter nach links angeordnet werden, wird mit Hilfe der vorbeschriebenen Verfahrensweise also die Stanzung für den Registerstift gegenüber der eigentlichen Nullage etwas weiter rechts angebracht. Dies führt dann dazu, daß beim Einfügen der Druckplatte in ihre Halterung an der Druckwalze die gewollte geringfügige Versetzung mehr nach links erfolgt.

Eine besonders einfache und zweckmäßige Ausgestaltung des Verfahrens kann dabei darin bestehen, daß für jede Stelle einer oder mehrerer Druckwalzen die dort auftretende Papierverformung für das jeweilige Druckverfahren und die jeweilige Papiersorte empirisch ermittelt und einem Rechner oder Computer in der Stanz- und/oder Biegemaschine eingegeben wird, der die Halterung für die Druckplatte ansteuert und beim Aufruf für die jeweils eingelegte Druckplatte entsprechend verstellt und einstellt, bevor sie mit ihren Verformungen versehen wird. Für jeden festliegenden Platz einer Druckplatte an der jeweiligen Druckwalze kann also empirisch der eventuell dort auftretende Papierfehler für unterschiedliche Papiersorten und auch unterschiedliche Druckfarben und dergleichen Parameter ermittelt und dem Rechner oder Computer eingegeben werden, so daß der Benutzer dann jeweils nur noch die entsprechenden Werte an dem Rechner aufzurufen hat, um die jeweilige Druckplatte in der Stanz- und/oder Biegemaschine auszurichten, bevor dann die den Papierfehler berücksichtigende Verformung an der Druckplatte automatisch angebracht wird.

Eine weitere Ausgestaltung der Erfindung und des erfinderischen Verfahrens kann darin bestehen, daß in den die Halterung für die Druckplatte ansteuernden Rechner oder Computer durch Verformungen an der Spannvorrichtung einer Druckwalze für Druckplatten bewirkte Maßänderungen eingegeben werden, so daß die nach einer solchen Verformung neu anzufertigende Druckplatte um das Maß dieser Verformung versetzt oder korrigiert gebogen und/oder gestanzt wird. Solche Verformungen können zum Beispiel bei einem Reißen der zu bedruckenden Papierbahn auftreten und machen normalerweise ein aufwendiges manuelles Unterlegen der Druckplatten im Bereich der dann zu berücksichtigenden Verformung erforderlich. Dies kann also aufgrund des erfindungsgemäßen Verfahrens ebenfalls vermieden oder vereinfacht werden.

Die erfindungsgemäße, eingangs genannte Vorrichtung zur Durchführung des Verfahrens ist vor allem dadurch gekennzeichnet, daß eine Halterung für die Druckplatte in der Stanz- und/oder Biegemaschine eine Ausrichtvorrichtung aufweist, mit welcher die Druckplatte in der Druckplattenebene in einer oder in zwei rechtwinklig zueinander stehenden Richtungen verstellbar und insbesondere verdrehbar angeordnet ist und daß wenigstens eine oder zwei Meßvorrichtungen zum Ausrichten vorgesehen sind, die vorzugsweise entsprechend einer zu erwartenden Papierverformung verstellbar sind. Durch eine solche Vorrichtung ist es möglich, eine Druckplatte in üblicher Weise in einer Stanz- und/oder Biegemaschine an einer Halterung zu fixieren, damit sie mit den erforderlichen Verformungen, also Umbiegungen oder Stanzungen für Registerstifte oder dergleichen versehen werden kann, wobei innerhalb der Stanz- und/oder Biegemaschine mit Hilfe einer Ausrichtvorrichtung und dem oder den Meßgeräten ein beim Drucken zu erwartender Papierfehler schon vorher mitberücksichtigt werden kann.

Besonders günstig ist es, wenn als Meßgeräte wenigstens zwei Videokameras vorgesehen sind, da die Technik zum Erfassen und Ausrichten mittels Videokameras hoch entwickelt ist und eine gute Genauigkeit erlaubt.

Die Ausrichtvorrichtung kann eine Drehscheibe, ein Drehkreuz, einen Drehtisch od.dgl. aufweisen, deren Oberfläche etwa bündig mit der Auflage oder Auflageplatte der Halterung der Biegevorrichtung in einer Aussparung oder in einem Zwischenraum dieser Auflage oder Auflageplatte angeordnet ist, und daß diese Drehscheibe innerhalb der Aussparung verdrehbar und außerdem in horizontaler Richtung in einer oder zwei rechtwinklig zueinander stehenden Richtungen verstellbar ist. Durch einen einfachen Mechanismus einer verdrehbaren Drehscheibe, die außerdem in X- und/oder Y-Richtung verstellt werden kann, kann also die darauf aufliegende Druckplatte - durch die Verknüpfung der Ansteuerung mit dem Rechner oder Computer - rechnergesteuert auf zu erwartende und empirisch ermittelte Papierfehler, also den "fan-out", eingestellt werden, so daß die Druckplatte von vorneherein die entsprechenden Verformungen hat, die bei der Befestigung an der Druckwalze dazu führen, daß die Druckplatte der Papierverformung gemäß versetzt an der Druckwalze befestigt wird.

Nachstehend ist ein Ausführungsbeispiel der Erfindung anhand der Zeichnung näher beschrieben. Es zeigt in schematisierter Darstellung:
- Fig.1: eine Ansicht von insgesamt vier in Vorschubrichtung hintereinander angeordneten Druckwalzen, deren jede jeweils acht Druckplatten trägt, wobei die zu bedruckende Papierbahn und insbesondere ihre seitlichen Ränder links und rechts von den Stirnseiten dieser Druckwalzen strichpunktiert dargestellt sind, wobei die parallel zueinander verlaufenden Linien eine ideale Papierbahn andeuten, während die davon jeweils nach außen von unten nach oben divergierenden Linien die Papierverformung während des Durchlaufes zwischen Druckwalzen von unten nach oben darstellen,
- Fig.2: eine Seitenansicht und
- Fig.3: eine Draufsicht einer Stanz- und/oder Biegemaschine, in der die an den Druckwalzen zu befestigenden Druckplatten mit Verformungen, nämlich Umbiegungen an den Rändern für ihre Halterung und Stanzungen zur genauen Justierung an den Registerstiften der Druckwalzen, versehen werden,
- Fig.4: eine Druckplatte, die an ihren beiden gegenüberliegenden Rändern mit Stanzungen für Registerstifte versehen ist, wobei jeweils benachbart zu diesen Stanzungen Markierungen erkennbar sind, die vor der Verformung der Druckplatte angebracht war und zum genauen Ausrichten der Druckplatte in der Stanz- und/oder Biegemaschine mit Hilfe von Videokameras dienen,
- Fig.5: das Blickfeld einer solchen Videokamera, bevor die Markierung und damit die Druckplatte lagerichtig ausgerichtet ist,
- Fig.6: die verschiedenen Ausrichtbewegungen für die Druckplatte in zwei rechtwinklig zueinander angeordneten Richtungen X und Y und in Drehrichtung Z,
- Fig. 7: eine der Fig.5 entsprechende Darstellung des Blickfeldes einer der Videokameras, nachdem die Markierung der Druckplatte in Übereinstimmung mit der entsprechenden Vorgabe in der Videokamera gebracht ist,
- Fig.8: eine der Fig.4 entsprechende Darstellung einer Druckplatte, bei welcher die Stanzungen gegenüber der genauen Anordnung in Fig.4 versetzt angeordnet sind, um einen Papierfehler an der Stelle einer Druckwalze zu berücksichtigen, an der diese Druckplatte anzubringen ist, wobei neben den Stanzungen wiederum die Markierungen oder Paßkreuze zum Zusammenwirken mit den entsprechend verstellten Videokameras dargestellt sind,
- Fig.9: das Blickfeld der Videokamera mit dem zentraien Paßkreuz der Nullstellung in dem Videosystem und dem demgegenüber verschobenen, außermittigen Paßkreuz als Markierung der zwar vor ausgerichteten, aber noch nicht genau justierten Druckplatte,
- Fig.10: eine der Fig.7 entsprechende Darstellung, bei welcher die beiden Markierungen gemäß Fig.9 in Übereinstimmung sind und
- Fig.11: das Blichfeld der Videokamera nach einer Korrektur zur Berücksichtigung des Papierfehlers sowie
- Fig.12: ein Schema für die empirische Ermittlung von Papierfehlern oder -verformungen, also Fan-Out-Daten für eine die Stanz- und/oder Biegemaschine und deren Ausrichtvorrichtung ansteuernden Rechner oder Computer.

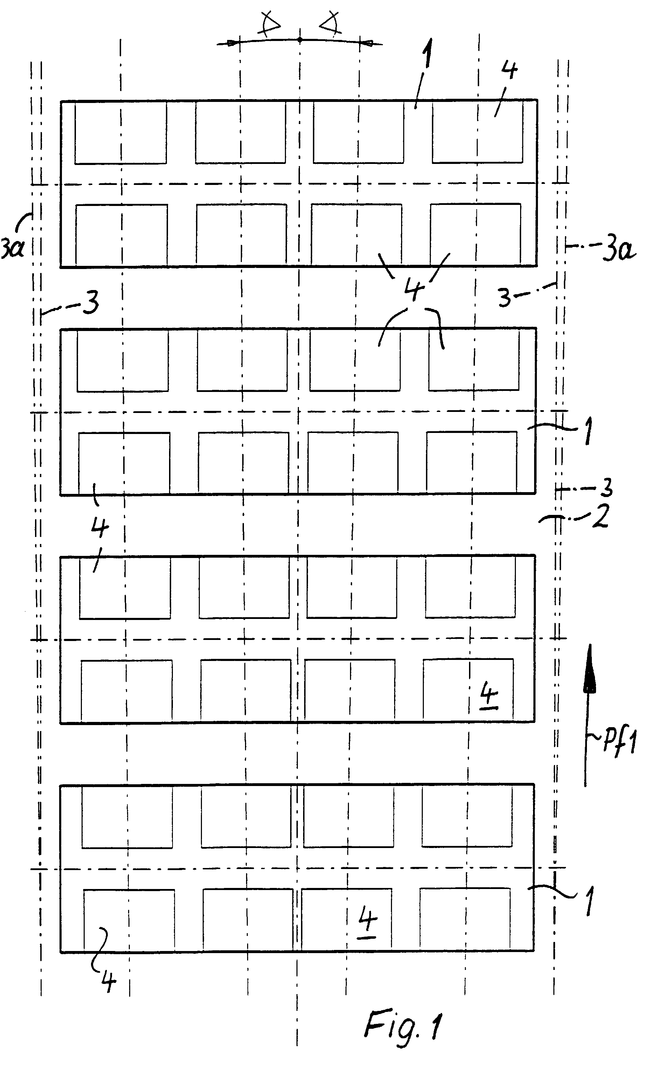

Von den im Ausführungsbeispiel vier Druckwalzenpaaren einer Druckmaschine ist in Fig.1 jeweils nur eine Druckwalze 1 dargestellt, wobei sich die Gegenwalze entweder über der Zeichenebene oder auch dahinter befinden kann. Die Vorschubrichtung einer zu bedruckenden Papierbahn 2 ist dabei in Fig.1 gemäß dem Pfeil Pf1 von unten nach oben gerichtet. Von der Papierbahn 2 sind dabei die seitlichen Begrenzungslinien 3 strichpunktiert dargestellt. Die parallelen Linien 3 entsprechen dabei einer normalen, keinerlei Verformung ausgesetzten Papierbahn, während die Linien 3a, die demgegenüber in Vorschubrichtung voneinander weg schräg verlaufen bzw. divergieren zu einer Papierbahn 2 gehören, die durch den Druckvorgang und die dabei auch von dem Papier aufgenommene Feuchtigkeit verformt werden. Somit zeigt der Unterschied zwischen den Linien 3 und 3a den Fan-Out dieser Papierbahn 2 in schematisierter Darstellung.

An den Druckwalzen 1 sind jeweils acht Druckplatten 4 angedeutet, wobei jeder Druckplatte 4 an der Druckwalze 1 eine bestimmte Stelle zugeordnet ist. Um nun die Divergenz oder das Fan-Out der Papierbahn 2 während ihres Durchlaufes durch die Druckwalzen 1 und während ihres Bedruckens mit unterschiedlichen Farben zu berücksichtigen, müssen vor allem die Druckplatten 4 an der in Vorschubrichtung letzten Walze gegenüber der dort dargestellten Position jeweils seitlich und gegebenenfalls auch in Umfangsrichtung der Druckwalze 1 versetzt angeordnet werden, so daß dadurch dann die mit der Verformung der Papierbahn etwas ausgewanderte zu bedruckende Stelle auch von dieser letzten Druckplatte richtig getroffen wird. Wichtig ist also, daß die an solchen Druckplatten 4 vorgesehenen Verformungen, nämlich am Rand vorhandene Umbiegungen zum Befestigen an entsprechenden Halterungen der Druckwalzen 1 und Ausstanzungen für ihre Justierung mit Hilfe von an den Druckwalzen 1 vorgesehenen Registerstiften an den Druckplatten 4 so angebracht werden, daß die Papierverformung automatisch berücksichtigt wird.

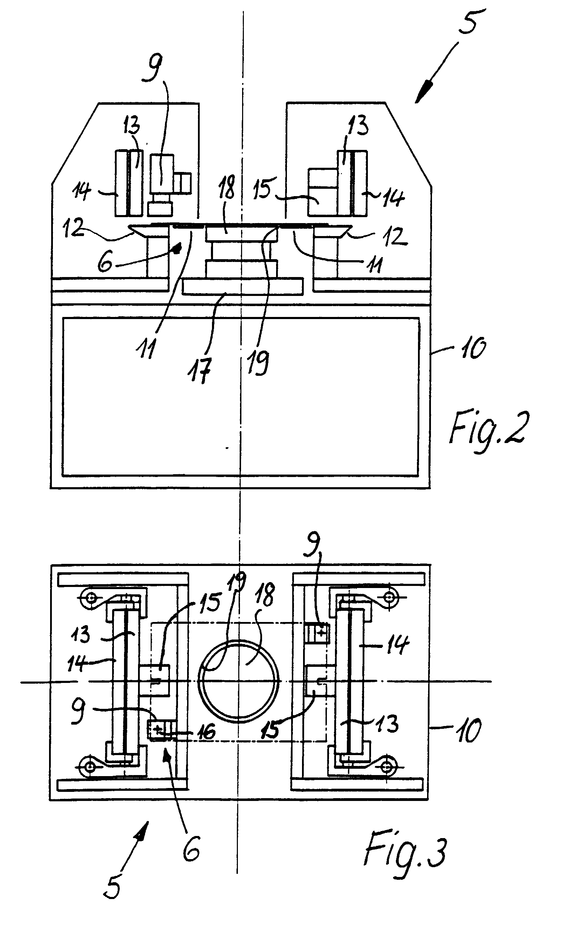

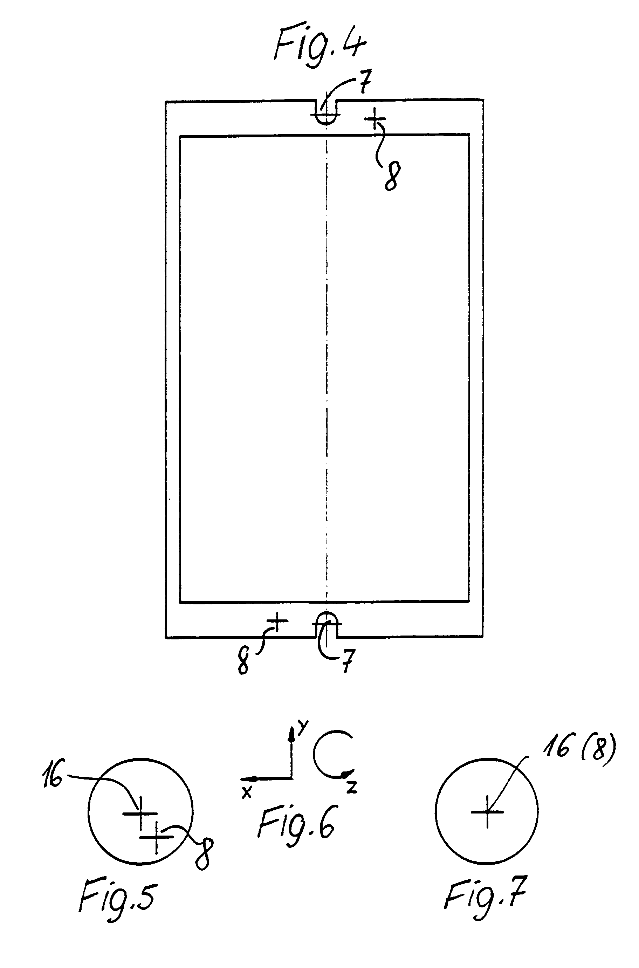

Dies wird dadurch erreicht, daß die jeweilige Druckplatte 4 bzw. eine sie in der in Fig.2 und 3 dargestellten Stanz- und/oder Biegemaschine 5 aufnehmende Halterung 6 um diejenigen Maße in seitlicher Richtung, in Umfangsrichtung der Druckwalzen 1 und/oder in ihrer Winkelstellung verstellt wird, die diese Druckplatte 4 an der Druckwalze 1 aufgrund der beschriebenen Verformung der zu bedruckenden Papierbahn 2 benötigt, um einen mit einer in Vorschubrichtung der Papierbahn vorhergehenden Druckwalze 1 übereinstimmenden Druck trotz der inzwischen erfolgten Papierverformung zu bewirken. Danach werden dann die Verformungen an dieser aus ihrer eigentlichen Nullage verstellten Druckplatte 4, also Umbiegungen und/oder Stanzungen 7, angebracht. In den Figuren 4 bis 7 ist schematisch angedeutet, wie eine Druckplatte 4 mit genau einer Nullage entsprechenden Stanzungen 7 versehen werden kann, das heißt diese Druckplatte 4 ist für die in Vorschubrichtung erste, in Fig.1 am weitesten unten dargestellte Druckwalze 1 geeignet.

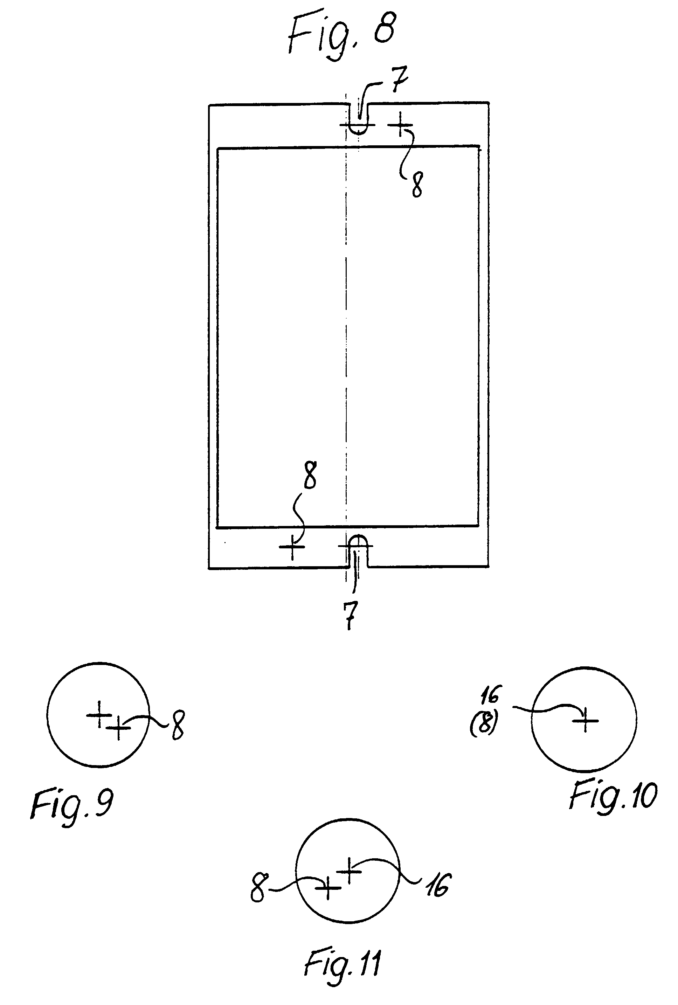

Diese Druckplatte 4 wird vor ihrer Verformung in die Stanz- und/oder Biegemaschine 5 eingelegt und vor ausgerichtet. Sie hat nahe den zu stanzenden Rändern Markierungen 8, die mit Hilfe von zwei Videokameras 9 erfaßt werden können. Fig.5 zeigt dabei, wie die entsprechende Markierung 16 in der Videokamera 9 zentral, die Markierung 8 der Druckplatte 4 aber noch unjustiert angeordnet sein können, wenn die Druckplatte 4 in der Stanz- und/oder Biegemaschine 5 vorjustiert ist. Gemäß Fig.6 kann die Druckplatte 4 dann in zwei unterschiedlichen Richtungen verschoben oder auch gedreht werden, um ihre Markierung 8 jeweils mit der der Videokamera gemäß Fig.7 in Übereinstimmung zu bringen. Wird nun an der Stanz- und/oder Biegemaschine die entsprechende Verformung durchgeführt, entstehen die lagegenauen Stanzungen 7 an der Druckplatte 5 gemäß der Darstellung in Fig.4.

Anstelle von Videokameras könnten auch andere Meßvorrichtungen, insbesondere optoelektronische oder auf Lasertechnologie, Infrarottechnologie, Schallwellentechnologie oder dergleichen beruhende Meßvorrichtungen vorgesehen sein.

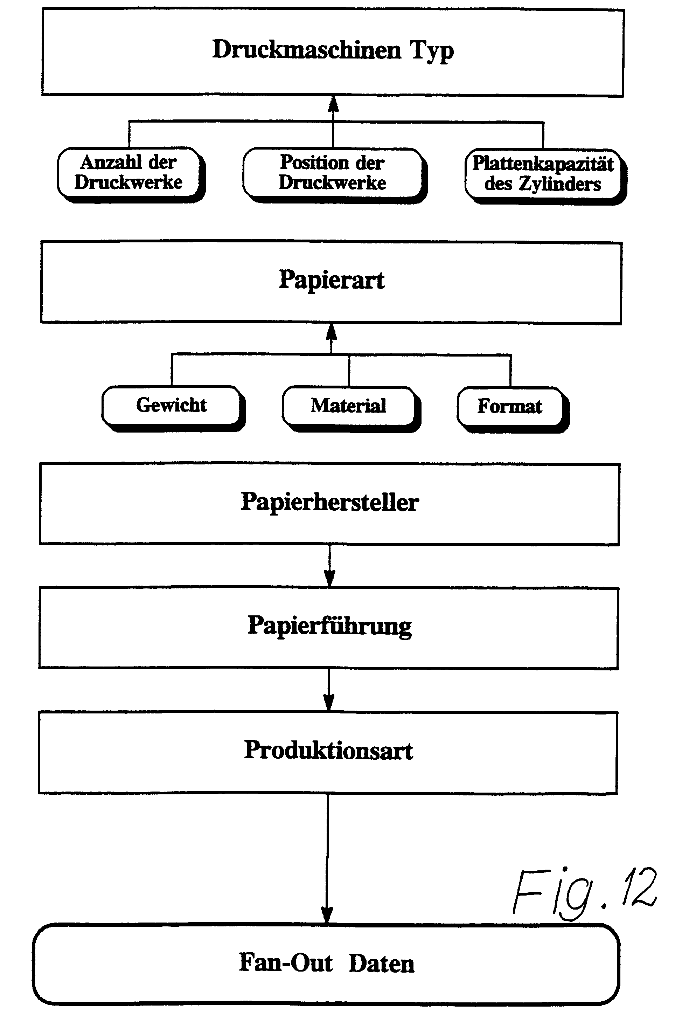

In Fig.8 ist wiederum eine Druckplatte 4 dargestellt, bei welcher die Stanzungen 7 aber gegenüber der Nullage um einen Papierfehler versetzt sind. Gemäß Fig.9 wird dabei wiederum die Druckplatte 4 zunächst in der Stanz- und/oder Biegemaschine vor ausgerichtet, danach gemäß Fig.10 zunächst genau ausgerichtet und dann durch eine noch zu beschreibende Berücksichtigung des später an dieser Druckplatte 4 zu erwartenden Papierfehlers so verstellt, so daß sich eine verschobene Position der Markierung 8 gegenüber der zentraien Markierung des Videosystemes ergibt, wie es in Fig.11 dargestellt ist. Wird dann die Druckplatte 4 mit ihren Verformungen versehen, entstehen die in Fig.8 erkennbaren Stanzungen 7, die gegenüber der eigentlichen Nullage versetzt sind. Die Druckplatte 4 wäre beispielsweise für die in Vorschubrichtung letzte Druckwalze aus Fig.1 geeignet.

In Fig.2 und 3 ist dargestellt, daß dabei die Druckplatten 4 in der Stanz- und/oder Biegemaschine 5 mit Hilfe wenigstens zweier Videokameras 9 ausgerichtet werden. Wie schon erwähnt, erfassen die Videokameras 9 die Markierungen 8 und die Videokameras 9 und die Druckplatten 4 sind verstellbar, so daß entweder eine genaue Justierung der Druckplatte 4 gemäß der Nullage möglich ist, wie es in den Figuren 7 und 10 angedeutet ist, oder es kann die jeweils zu erwartende Papierverformung etwa gemäß Fig.ll berücksichtigt werden.

Anhand der Fig.1 wird deutlich, daß die im Verlaufe des Druckverfahrens auftretende Papierverformung an den einzelnen Druckwalzen 1 verschieden ist, beispielsweise von Druckwalze zu Druckwalze zunimmt, aber sich auch an den einzelnen Druckwalzen unterschiedlich auswirkt. Es leuchtet ein, daß in der Mitte der Papierbahn eine Papierverformung weniger stark als an den den Außenrändern 3a benachbarten Bereichen ist.

Es ist deshalb vorgesehen, daß für jede Stelle der Druckwalzen 1 einer Druckmaschine mit mehreren Druckwalzen 1 die dort auftretende Papierverformung für das jeweilige Druckverfahren und die jeweilige Papiersorte empirisch ermittelt wird, das heißt es werden entsprechende Probedrucke durchgeführt und nachgemessen oder die Probedrucke werden auf Millimeterpapier ausgeführt, um von Druckwalze zu Druckwalze die durch die Papierverformungen bewirkten Abweichungen der einzelnen Drucke voneinander sofort zu bestimmen und ausmessen zu können. Diese empirisch ermittelten Werte, die von der Druckmaschine selbst, den Druckwalzen 1, dem verwendeten Papier und auch den verwendeten Druckfarben und dergleichen abhängen, werden in einen in der Zeichnung nicht näher dargestellten Rechner oder Computer eingegeben, der zu der Stanz- und/oder Biegemaschine 5 gehört. Dieser kann dann die schon erwähnte Halterung 6 für die Druckplatte 4 ansteuern und bei Aufruf die jeweils eingelegte Druckplatte 4 entsprechend verstellen und einstellen, bevor sie mit ihrer Verformung, also ihrer Umbiegung und Stanzung 7, versehen wird. In Fig.12 ist noch einmal schematisiert dargestellt, wie die Daten zur Berücksichtigung der Papierverformung, also des Fan-Out ermittelt oder festgelegt werden. Daraus ergibt sich, daß zunächst einmal der Druckmaschinentyp berücksichtigt wird und zwar bezüglich der Anzahl der Druckwerke, also der Druckwalzenpaare, der Position der Druckwerke und der Kapazität an Druckplatten der einzelnen Druckwalzen oder Zylinder.

Darüber hinaus ist für die Papierverformung natürlich die verwendete Papierart von ganz erheblicher Bedeutung und zwar hinsichtlich des Flächengewichtes, des eigentlichen Materiales und auch des Formates.

Dabei kann vor allem auch der Papierhersteller, im übrigen die Papierführung und die Produktionsart des Papieres eine Rolle spielen. All diese einzelnen Daten und Kennzeichnungen sind also bei der empirischen Ermittlung der Papierverformung mitzuberücksichtigen und als entsprechende Daten in den Rechner einzugeben, um anschließend bei der entsprechenden Druckmaschine je nach Papierart und Papierhersteller von vorneherein die richtige Berücksichtigung einer Papierverformung an der Stanz- und/oder Biegemaschine mehr oder weniger automatisch und gleichbleibend berücksichtigen zu können.

Es ist bekannt, daß gelegentlich eine Papierbahn 2 während des Druckvorganges zerreißt und dann die eine oder andere Druckwalze einer zusätzlichen Belastung ausgesetzt wird, indem sich Papier mehrfach auf sie aufwickeln kann. Dies kann zu Verformungen im Bereich der Druckplattenhalterungen führen, die für den weiteren Druck korrigiert werden muß. Dabei ist es möglich, in den die Halterung für die Druckplatte ansteuernden Rechner oder Computer durch Verformungen an der Spannvorrichtung einer Druckwalze 1 für Druckplatten 4 bewirkte Maßänderung in gleicher Weise einzugeben, wie dies mit den zu erwartenden Abmessungsänderungen der Papierbahn in der vorbeschriebenen Weise geschieht, so daß die nach einer solchen Verformung der Druckwalze 1 neu anzufertigende Druckplatte 4 um das Maß dieser Verformung versetzt oder korrigiert gebogen und/oder gestanzt wird. Somit können auch solche Verformungen oder Beschädigungen sehr schnell und problemlos für die weiteren Druckvorgänge ausgeglichen werden.

In den Figuren 2 und 3 ist die schon mehrfach erwähnte Stanz- und/oder Biegemaschine 5 zum Anbringen der Verformungen, also beispielsweise der Stanzungen 7 für die Registerstifte von Druckwalzen 1 an den Druckplatten 4 und/oder für im Randbereich vorzusehende Umbiegungen zur Befestigung der Druckplatte 4 an der Druckwalze 1 schematisiert dargestellt. Dabei erkennt man in Fig.2 ein Grundgestell 10 der im ganzen mit 5 bezeichneten Maschine, welches Grundgestell 10 eine an sich bekannte Auflage in Form einer Auflageplatte 11 und vor allem auch die Biegeeinsätze 12, Niederhalter 13, Biegestempel 14 und Stanzeinheiten 15 in an sich bekannter Weise trägt. Außerdem erkennt man vor allem in Fig.3, daß zwei Videokameras 9 zum Ausrichten auf die Markierungen 8 vorgesehen sind, die ihrerseits entsprechende Markierungen 16 enthalten, wie es in den Figuren 5 und 7 sowie 9 bis 11 angedeutet ist. Die Wirkungsweise der Markierungen 8 und ihr Zusammenwirken mit der Markierung 16 der Videokameras 9 wurde schon erwähnt. Bei einer normalen Stanzung einer Druckplatte 4 gemäß Fig.4 werden die beiden Markierungen 8 und 16 gemäß Fig.7 in Übereinstimmung gebracht, nachdem sie zuvor durch eine Vorjustierung der Druckplatte 4 gemäß Fig.5 nur ungefähr in die Nähe zueinander gebracht wurden.

Für die bewußte Berücksichtigung des Papierfehlers hingegen wird gemäß Fig.11 die Markierung 8 dann um den zu erwartenden Papierfehler gegenüber der Markierung 16 aus der zunächst präzise justierten Position der Fig.10 wieder verschoben.

Die die Auflageplatte 11 umfassende Halterung 6 der Maschine 5 weist dazu eine Ausrichtvorrichtung 17 auf, mit welcher die von ihr erfaßte Druckplatte 4 in der Druckplattenebene in einer oder in zwei rechtwinklig zueinanderstehenden Richtungen, gemäß Fig.6 in X-Richtung und in Y-Richtung verstellbar und außerdem gemäß dem kreisförmig gekrümmten Pfeil in Z-Richtung verdrehbar ist. Die beiden Viedeokameras 9 sind ebenfalls verstellbar und werden zur Einstellung bzw. Positionierung zu den als Paßkreuze ausgebildeten Markierungen 8 auf der jeweiligen Druckplatte 4 manuell eingestellt, wonach dann diese Einstellung während des gesamten weiteren Bearbeitungsvorganges erhalten bleibt.

Die Ausrichtvorrichtung 17 hat dabei eine Drehscheibe 18, deren Oberfläche etwa bündig mit der Auflageplatte 11 der Halterung 6 der Maschine 5 in einer Aussparung 19 dieser Auflageplatte 11 angeordnet, was auch dadurch realisiert sein kann, daß die Auflageplatte 11 aus zwei entsprechend beabstandeten Einzelplatten besteht.

Die Drehscheibe 18 ist innerhalb der Aussparung 19 bzw. dem Abstand verdrehbar und außerdem in horizontaler Richtung verstellbar, so daß eine auf ihr aufliegende und befestigte Druckplatte entsprechend verstellt werden kann, wobei die Ausrichtvorrichtung 17 von dem schon erwähnten Rechner angesteuert wird, so daß die Eingabe der Fan-Out-Daten in den Rechner dazu führen, daß die Druckplatte 4 dem jeweils zu erwartenden Papierfehler gemäß justiert und dann mit ihren Verformungen versehen wird, die diesen Papierfehler berücksichtigen.

In vorteilhafter Weise werden also die einzelnen Druckplatten 4 an den ihnen zugeordneten Stellen der Druckwalzen 1 in einer unter Umständen gegenüber der Nullage etwas versetzten und verdrehten Position befestigt, wodurch von vorneherein der an dieser jeweiligen Stelle der Druckwalze zu erwartende Fan-Out des Papieres während des Druckvorganges berücksichtigt wird, so daß aufwendige Verstellungen der Druckplatten (4) nach entsprechend vielen Probedrucken relativ zu den Druckwalzen (1) vermieden werden.

Das Verfahren und die Vorrichtung zur Anpassung der Lage von Druckplatten 4 an die Verformung (FAN-OUT) der zu bedruckenden Papierbahn 2 durch Feuchtigkeit, Farbaufnahme und auch mechanische Beanspruchung beim Durchlauf durch mehrere hintereinander angeordnete Paare von Druckwalzen 1 und auch zur Anpassung an an der Einspannvorrichtung einer Druckwalze 1 unter Umständen auftretende Verformungen und dadurch erzeugte Lageänderungen einer jeweiligen Druckplatte 4 sieht vor, daß die Druckplatte 4 bzw. die sie in der Stanz- und/oder Biegemaschine 5 aufnehmende Halterung jeweils um diejenigen Maße in seitlicher Richtung, in Umfangsrichtung und/oder in ihrer Winkelstellung verstellt oder versetzt wird, die diese Druckplatte 4 an der Druckwalze 1 aufgrund der erwähnten Verformung der zu bedruckenden Papierbahn 2 benötigt, um einen mit einer in Vorschubrichtung der Papierbahn 2 vorhergehenden Druckwalze 1 übereinstimmenden Druck trotz der inzwischen erfolgten Papierverformung zu bewirken, und daß danach die Verformungen, also Umbiegungen und/oder Stanzungen 7, an dieser aus ihrer Nullage verstellten Druckplatte 4, angebracht werden, wozu vor allem eine rechnergesteuerte Ausrichtvorrichtung 17 in der Druck- und/oder Stanzmaschine 5 verwendet wird, nachdem dem Rechner die entsprechenden Daten der Papierbahn, der Druckmaschine und der Produktionsart eingegeben sind.

## Patentansprüche

1. Verfahren zur Anpassung der Lage von Druckplatten (4) an die Verformung (Fan-Out) des zu bedruckenden Papieres durch Feuchtigkeit und Farbaufnahme beim Durchlauf durch mehrere hintereinander angeordnete Paare von Druckwalzen (1) und/oder zur Anpassung an an der Einspannvorrichtung einer Druckwalze (1) auftretende Verformungen und dadurch erzeugte Lageänderungen einer jeweiligen Druckplatte (4), wobei die Druckplatte bei ihrer Herstellung mit Markierungen für eine lagegenaue Stanzung und/oder Biegung versehen und damit in eine Stanz- und/oder Biegemaschine eingelegt und den Markierungen gemäß darin justiert und ausgerichtet wird, wobei die Druckplatte (4) bzw. die sie in der Stanz- und/oder Biegemaschine (5) aufnehmende Halterung (6) um diejenigen Maße in seitlicher Richtung, in Umfangsrichtung und/oder in ihrer Winkelstellung verstellt wird, die diese Druckplatte (4) an der Druckwalze (1) aufgrund der Verformung der zu bedruckenden Papierbahn (2) benötigt, um einen mit einer in Vorschubrichtung der Papierbahn (2) vorhergehenden Druckwalze (1) übereinstimmenden Druck trotz der inzwischen erfolgten Papierverformung zu bewirken, wonach die Verformungen an dieser aus ihrer Nullage verstellten Druckplatte (4), also Umbiegungen und/oder Stanzungen (7), angebracht werden.

2. Verfahren nach Anspruch 1, dadurch gekennzeichnet, daß die Druckplatte (4) in der Stanz- und/oder Biegemaschine (5) mit Hilfe wenigstens einer, insbesondere zweier Meßvorrichtungen,z.B.optoelektronischer Meßvorrichtungen, Lasertechnik, Infrarottechnologie, Schallwellen- oder Ultraschallwellentechnologie, insbesondere mit Hilfe wenigstens zweier Videokameras (9) ausgerichtet wird, welche Meßvorrichtungen die Markierungen (8) erfassen, und daß die Druckplatten (4) so verstellbar sind, daß die jeweils zu erwartende Papierverformung berücksichtigt wird.

3. Verfahren nach Anspruch 1 oder 2, dadurch gekennzeichnet, daß für jede Stelle einer oder mehrerer Druckwalzen (1) einer Druckmaschine mit mehreren Druckwalzen (1) die dort auftretende Papierverformung für das jeweilige Druckverfahren und die jeweilige Papiersorte empirisch ermittelt und einem Rechner oder Computer in der Stanz- und/oder Biegemaschine eingegeben wird, der die Halterung (6) für die Druckplatte (4) ansteuert und beim Aufruf die jeweils eingelegte Druckplatte (4) entsprechend verstellt und eingestellt, bevor sie mit ihren Verformungen versehen wird.

4. Verfahren nach einem der Ansprüche 1 bis 3, dadurch gekennzeichnet, daß in den die Halterung für die Druckplatte ansteuernden Rechner oder Computer durch Verformungen an der Spannvorrichtung einer Druckwalze (1) für Druckplatten bewirkte Maßänderungen eingegeben werden, so daß die nach einer solchen Verformung neu anzufertigende Druckplatte (4) um das Maß dieser Verformung versetzt oder korrigiert gebogen und/oder gestanzt wird.

5. Vorrichtung zur Durchführung des Verfahrens nach einem der Ansprüche 1 bis 4, mit einer Stanz- und/oder Biegemaschine (5) zum Anbringen der Stanzung (7) für die Registerstifte von Druckwalzen (1) an Druckplatten (4) und/oder für die Umbiegung zur Befestigung der entsprechenden Druckplatte an der Druckwalze, dadurch gekennzeichnert, daß eine Halterung für die Druckplatte in der Stanz- und/oder Biegemaschine eine Ausrichtvorrichtung (17) aufweist, mit welcher die Druckplatte (4) in der Druckplattenebene in einer oder in zwei rechtwinklig zueinander stehenden Richtungen verstellbar und insbesondere verdrehbar angeordnet ist und daß wenigstens eine oder zwei Meßvorrichtungen zum Ausrichten vorgesehen sind, die vorzugsweise entsprechend einer zu erwartenden Papierverformung verstellbar sind.

6. Vorrichtung nach Anspruch 5, dadurch gekennzeichnet, daß als Meßvorrichtung wenigstens zwei Videokameras (9) vorgesehen sind.

7. Vorrichtung nach Anspruch 5 oder 6, dadurch gekennzeichnet, daß die Ausrichtvorrichtung (17) eine Drehscheibe (18), ein Drehkreuz, einen Drehtisch od.dgl. aufweist, deren Oberfläche etwa bündig mit der Auflage oder Auflageplatte (11) der Halterung (6) der Biegevorrichtung (5) in einer Aussparung oder in einem Zwischenraum (19) dieser Auflage oder Auflageplatte (11) angeordnet ist, und daß diese Drehscheibe (18) innerhalb der Aussparung (19) verdrehbar und außerdem in horizontaler Richtung in einer oder zwei rechtwinklig zueinander stehenden Richtungen verstellbar ist.

## Claims

1. Process for adapting the position of printing plates (4) to the deformation (fan-out) of the paper to be printed caused by humidity and colour uptake on passing through a plurality of pairs of printing rollers (1) arranged one after another, and/or for adapting to deformations occurring at the gripping device of a printing roller (1) and resultant changes in position of a printing plate (4), the printing plate being provided, during manufacture, with markings for accurate punching and/or bending and hence being inserted in a punching and/or bending machine and adjusted and aligned therein in accordance with the markings, the printing plate (4) or the holder (6) which accommodates it in the punching and/or bending machine (5) being moved in the lateral direction, in the circumferential direction and/or in its angular position by the amount required by this printing plate (4) at the printing roller (1) on the basis of the deformation of the web of paper (2) which is to be printed, in order to achieve an impression which is identical to a preceding printing roller (1) in the direction of advance of the web (2), in spite of the deformation of the paper which has occurred in the meantime, after which the deformations, i.e. bends and/or punchings (7), are applied to this printing plate (4) moved out of its zero position.

2. Process according to claim 1, characterised in that the printing plate (4) is aligned in the punching and/or bending machine (5) with the aid of at least one, particularly two measuring devices, e.g. optoelectronic measuring devices, laser technology, infra-red technology, sound wave or ultrasound wave technology, particularly with the aid of at least two video cameras (9), these measuring devices detecting the markings (8), and in that the printing plates (4) are movable so as to take account of the expected deformation of the paper.

3. Process according to claim 1 or 2, characterised in that for each location of one or more printing rollers (1) of a printing machine with a plurality of printing rollers (1) the paper deformation occurring for the particular printing process and the particular type of paper is determined empirically and fed into a calculator or computer in the punching and/or bending machine which actuates the holder (6) for the printing plate (4) and when called up the printing plate (4) inserted is correspondingly moved and adjusted before being subjected to deformation.

4. Process according to one of claims 1 to 3, characterised in that changes in dimensions brought about by deformations at the gripping device of a printing roller (1) for printing plates are fed into the calculator or computer controlling the holder for the printing plate, so that the new printing plate (4) to be produced after such deformation is bent and/or punched having been offset or corrected by the amount of this deformation.

5. Device for carrying out the process according to one of claims 1 to 4, with a punching and/or bending machine (5) for providing printing plates (4) with the punched holes (7) for the locating pins of printing rollers (1) and/or for bending the printing plate in question in order to secure it on the printing roller, characterised in that a holder for the printing plate in the punching and/or bending machine has an aligning device (17) with which the printing plate (4) is movable, in the plane of the printing plate, in one direction or in two directions at right angles to one another, and in particular is rotatable, and in that at least one or two measuring devices are provided for alignment which are preferably movable in accordance with the expected deformation of the paper.

6. Device according to claim 5, characterised in that at least two video cameras (9) are provided as a measuring device.

7. Device according to claim 5 or 6, characterised in that the aligning device (17) is a turntable (18), a capstan, a rotary table or the like, the surface of which is arranged substantially flush with the support or support plate (11) of the holder (6) for the bending apparatus (5) in a recess or gap (19) in this support or support plate (11), and in that this turntable (18) is rotatable inside the recess (19) and is also horizontally movable in one or two directions at right angles to each other.

## Revendications

1. Procédé pour l'adaptation de la position de plaques d'impression (4) à la déformation (fan-out/tuilage) du papier à imprimer due à l'humidité et à l'absorption de l'encre lors du passage dans plusieurs paires de rouleaux imprimeurs (1) placées les unes derrière les autres et/ou pour l'adaptation aux déformations produites sur le dispositif de serrage d'un rouleau imprimeur (1) et aux modifications de position d'une plaque d'impression (4) correspondante ainsi créées, la plaque d'impression étant munie, lors de sa fabrication, de repères pour un poinçonnage et/ou un pliage à la position exacte et étant ainsi insérée dans une machine à poinçonner et/ou plier et y étant ajustée et réglée en fonction des repères, la plaque d'impression (4) ou le support (6) la logeant dans la machine à poinçonner et/ou plier (5) étant déplacée, en direction latérale, en sens cironférentiel et/ou dans sa position angulaire, des dimensions que nécessite cette plaque d'impression (4) sur le rouleau imprimeur (1) en raison de la déformation de la bande de papier (2) à imprimer pour effectuer une pression correspondant à un rouleau imprimeur (1) précédent en sens d'avancement de la bande de papier (2) malgré la déformation du papier réalisée entre temps, après quoi les déformations, donc des pliages et/ou des poinçons (7), sont apportées sur cette plaque d'impression (4) déplacée hors de sa position zéro.

2. Procédé selon la revendication 1, **caractérisé en ce que** la plaque d'impression (4) est alignée dans la machine à poinçonner et/ou plier (5) à l'aide d'au moins un, en particulier deux, dispositifs de mesure , p. ex. de dispositifs de mesure optoélectronique, technique laser, technologie infra-rouge, technologie d'onde sonores ou ultra sons, en particulier à l'aide d'au moins deux caméras vidéo (9) lesquels dispositifs de mesure enregistrent les repères (8) et **en ce que** les plaques d'impression (4) sont ajustables de telle façon que la déformation respective attendue du papier est prise en compte.

3. Procédé selon la revendication 1 ou 2, **caractérisé en ce que** pour chaque endroit d'un ou de plusieurs rouleaux imprimeurs (1) d'une presse ayant plusieurs rouleaux imprimeurs (1) la déformation du papier produite à cet endroit est calculée de façon empirique pour le procédé d'impression respectif et le type de papier respectif et est saisie dans un ordinateur dans la machine à poinçonner et/ou à plier, ordinateur qui commande le support (6) de la plaque d'impression (4) et, lors de l'appel, déplace et ajuste de façon correspondante la plaque d'impression (4) respectivement insérée, avant que celle-ci ne soit munie de ses déformations.

4. Procédé selon l'une des revendications 1 à 3, **caractérisé en ce que,** sur l'ordinateur commandant le support de la plaque d'impression, on saisit des modifications de dimension causées par des déformations sur le dispositif de serrage d'un rouleau imprimeur (1) pour des plaques d'impression, de sorte que la nouvelle plaque d'impression (4) à fabriquer selon une telle déformation est pliée et/ou poinçonnée de la dimension de cette déformation de manière décalée ou corrigée.

5. Dispositif pour la réalisation du procédé selon l'une des revendications 1 à 4, avec une machine à poinçonner et/ou plier (5) pour réaliser le poinçonnage (7) pour les tétons de repérage de rouleaux imprimeurs (1) sur des plaques d'impression (4) et/ou pour le pliage pour fixer la plaque d'impression correspondante sur le rouleau imprimeur, **caractérisé en ce qu**'un support de la plaque d'impression dans la machine à poinçonner et/ou plier présente un dispositif d'alignement (17) avec lequel la plaque d'impression (4) est placée de manière réglable au niveau des plaques d'impression dans une ou deux direction(s) à angle droit l'une par rapport à l'autre et notamment de façon pivotante, et en ce qu'au moins un ou deux dispositifs de mesure sont prévus pour l'alignement, qui de préférence sont ajustables de façon correspondante par rapport à une déformation attendue du papier.

6. Dispositif selon la revendication 5, **caractérisé en ce qu**'au moins deux caméras vidéo (9) sont prévues comme dispositif de mesure.

7. Dispositif selon la revendication 5 ou 6, **caractérisé en ce que** le dispositif d'alignement (17) présente une plaque tournante (18), un tourniquet, une table tournante ou un dispositif similaire, dont la surface supérieure est placée à peu près au niveau du support ou de la plaque de support (11) du support (6) du dispositif de pliage (5) dans un évidement ou dans un espace intermédiaire (19) de ce support ou plaque de support (11), et en ce que cette plaque tournante (18) peut pivoter dans cet évidement (19) et qu'en outre elle est réglable dans le sens horizontal dans une ou deux directions à angle droit l'une par rapport à l'autre.
